# EUROPÄISCHE PATENTSCHRIFT

(11) **EP 0 827 604 B1**
(45) Veröffentlichungstag und Bekanntmachung des Hinweises auf die Patenterteilung: **24.02.1999**
(21) Anmeldenummer: 96913455.0
(22) Anmeldetag: 02.05.1996
(51) Int. Cl.: G05F 3/24

(54) **KONSTANTSTROMQUELLE MIT EINER EEPROM-ZELLE**
CONSTANT CURRENT SOURCE WITH AN EEPROM CELL
SOURCE DE COURANT CONSTANT POURVUE D'UNE CELLULE EEPROM

(30) Priorität: 22.05.1995 DE 19518728
(43) Veröffentlichungstag der Anmeldung: 11.03.1998
(73) Patentinhaber: SIEMENS AKTIENGESELLSCHAFT, 80333 München (DE)
(72) Erfinder: ZETTLER, Thomas, D-81737 München (DE)
(86) Internationale Anmeldenummer: DE9600762
(87) Internationale Veröffentlichungsnummer: WO9637814

(56) Entgegenhaltungen:
- EP-A- 0 621 603
- GB-A- 2 259 376
- US-A- 4 104 575
- US-A- 4 375 087

## Beschreibung

Die Erfindung betrifft eine Konstantstromquelle nach dem Oberbegriff des Anspruchs 1.

Eine solche Konstantstromquelle ist beispielsweise aus "Halbleiterschaltungstechnik" von Tietze, Schenk, 6. Auflage, 1983, Seiten 94, 95 bekannt. Hierbei ist ein Feldeffekttransistor vom Verarmungstyp, also ein selbstleitender Feldeffekttransistor verwendet, wodurch sich diese Stromquelle in vorteilhafter Weise als Zweipol verwenden läßt, da das Steuergate nicht mit einer Hilfsspannung, deren Erzeugung zusätzliche Schaltungsmittel erfordern würde, beaufschlagt werden muß.

Nachteilig ist bei einem solchen selbstleitenden Feldeffekttransistor jedoch, daß es bei konventionellen Herstellungsprozessen für CMOS- oder BICMOS-Schaltungen zusätzlicher Prozeßschritte bedarf.

Die US 4,375,087 offenbart eine EEPROM-Speicherzelle, die mit einem n-Kanal-MOS-Transistorgebildet ist, der mit einem sich zwischen dem Kanal und dem Steuergate angeordneten, sich auf schwebendem Zustand befindenden, vollkommen isolierten Gate ausgestattet ist. Zum Programmieren der Zelle werden Elektronen auf das Gate aufgebracht, die beim Löschen wieder entfernt werden.

Die Aufgabe vorliegender Erfindung besteht darin, eine Konstantstromquelle anzugeben, die, insbesondere bei einer MOS-Technologie mit EEPROM-Zellen, obengenannte Nachteile vermeidet.

Die Aufgabe wird bei einer gattungsgemäßen Konstantstromquelle mit den Merkmalen des kennzeichnenden Teils des Anspruchs 1 gelöst.

Durch die sich auf dem schwebenden Gate befindende Ladung werden Minoritätsträger des Halbleitersubstrats, in dem der Feldeffekttransistor realisiert ist, in den Kanalbereich gezogen, so daß ein selbstleitender Feldeffekttransistor, also ein Quasi-Verarmungstyp-FET entsteht, ohne daß zusatzliche Prozeßschritte erforderlich waren.

Die Ladung vom zum Kanaltyp entgegengesetzten Ladungstragertyp erhalt man durch einen sogenannten "Over-Erase"-Vorgang, also einen Löschvorgang über den neutralen Zustand hinaus.

Bei EEPROMs vom beispielsweise n-Kanal-Typ wird zum Programmieren an das Steuergate eine hohe positive Spannung von etwa 18 Volt und an die Drain eine Spannung von etwa 5 V gelegt, wahrend die Source mit Masse verbunden ist. Von den im Kanalbereich fließenden Elektronen gelangen sogenannte "heiße" Elektronen auf das sich zwischen dem Steuergate und dem Kanal befindende schwebende Gate, wodurch die Einsatzspannung der EEPROM-Zelle zu positiven Werten verschoben wird. Zum Löschen dieser Zelle wird an das Gate das Massepotential angelegt und an die Source eine positive Hochspannung, wahrend der Drainanschluß in schwebendem Zustand gelassen wird. Durch diese Beschaltung tunneln die Elektronen vom schwebenden Gate in die Source. Wird die Löschspannung zu lange angelegt, werden mehr Elektronen in die Source tunneln, als zuvor durch die Programmierung mittels heißer Elektronen dorthin gelangten, so daß sich das schwebende Gate positiv auflädt, wodurch ein selbstleitender Feldeffekttransistor entsteht. Dieser wird in erfindungsgemäßer Weise als Konstantstromquelle genutzt.

Die Erfindung wird nachfolgend anhand eines Ausführungsbeispiels mit Hilfe von Figuren naher erlautert. Dabei zeigen:
- Figur 1: eine schematische Darstellung einer in einem Halbleitersubstrat realisierten EEPROM-Zelle,
- Figur 2: deren Ersatzschaltbild,
- Figur 3: die Beschaltung einer EEPROM-Zelle, um sie zu löschen beziehungsweise in den "Over-Erased"-Zustand zu bringen und
- Figur 4: eine erfindungsgemäße Konstantstromquelle.

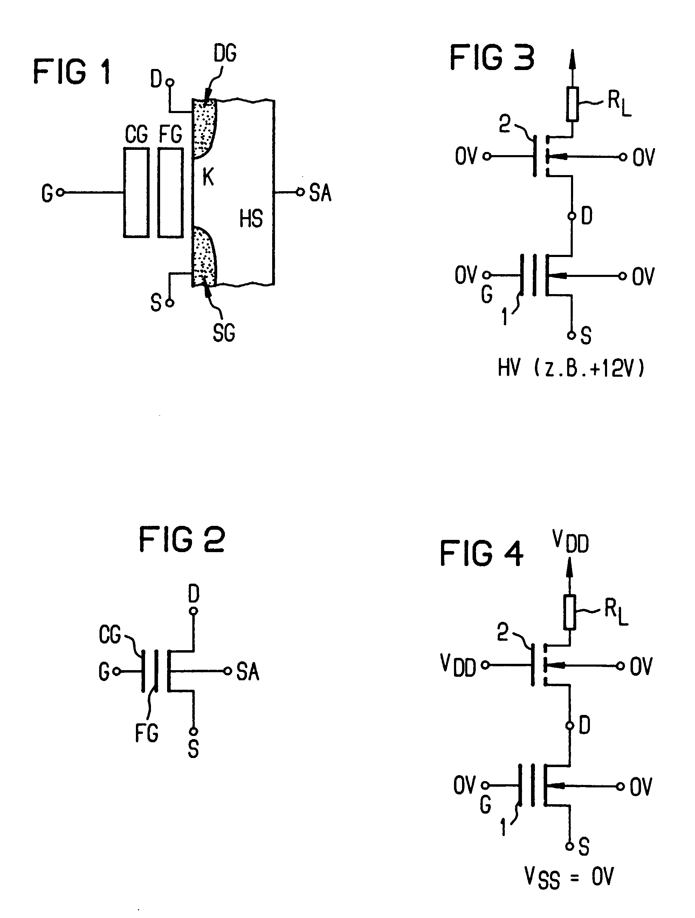

In Figur 1 ist ein Querschnitt durch eine schematische Darstellung einer in einem Halbleitersubstrat HS realisierten EEPROM-Zelle dargestellt. Im Halbleitersubstrat HS ist sowohl ein Draingebiet DG als auch ein Sourcegebiet SG ausgebildet, wobei diese Gebiete einen zum Halbleitersubstrat HS entgegengesetzten Dotierungstyp aufweisen. Zwischen dem Draingebiet DG und dem Sourcegebiet SG kann sich im Halbleitersubstrat HS ein leitender Kanal K ausbilden. Über dem Kanalgebiet K des Halbleitersubstrats HS ist ein vom Kanalgebiet K durch eine Isolatorschicht, die beispielsweise eine Oxidschicht sein kann, isoliertes schwebendes Gate FG und über diesem ein ebenfalls durch eine Isolatorschicht isoliertes Steuergate CG angeordnet. Das Steuergate CG weist einen Gateanschluß G, das Sourcegebiet SG einen Sourceanschluß S und das Draingebiet DG einen Drainanschluß D auf. Das Halbleitersubstrat HS weist einen Substratanschluß SA auf. In Figur 2 ist ein Ersatzschaltbild für eine solche EEPROM-Zelle dargestellt.

Zum Programmieren einer solchen EEPROM-Zelle werden an die Drain- und Sourceanschlüsse D, S Potentiale angelegt, die einen Stromfluß im Kanalbereich K ermöglichen. An den Gateanschluß G wird ein Potential angelegt, das eine zu den Minoritätsträgern im Halbleitersubstrat HS entgegengesetzte Polaritat aufweist. Dadurch werden diese in den Kanalbereich gezogen und führen zu einem verstärkten Stromfluß. Wenn das Potential am Gateanschluß G sehr hoch gewahlt wird, können sogenannte "heiße" Elektronen durch das Gateoxid hindurch auf das schwebende Gate FG gelangen. Dadurch lädt sich dieses auf, wodurch Minoritatstrager aus dem Kanalbereich K abgedrängt werden. Durch diesen Mechanismus wird die Einsatzspannung der EEPROM-Zelle zu höheren Werten hin verschoben. Bei einer n-Kanal-EEPROM-Zelle würde sich also das schwebende Gate negativ aufladen, wodurch die Einsatzspannung der Zelle zu positiveren Werten hin verschoben würde. Zum Lesen aus dieser Zelle würde an das Gate eine Spannung angelegt werden, die zwischen den Einsatzspannungen einer nicht programmierten und einer programmierten Zelle liegen würde. Abhängig von der Größe des dann erfolgenden Stromflusses ließe sich dann eine logische "0" oder eine logische "1" aus der Zelle auslesen. Zum Löschen einer solchen Zelle müssen die Ladungstrager wieder vom schwebenden Gate entfernt werden.

Eine prinzipielle Beschaltung einer EEPROM-Zelle für den Löschvorgang ist in Figur 3 dargestellt. Der in Serie zu der EEPROM-Zelle geschaltete n-Kanal-MOSFET 2 ist dabei gesperrt, so daß der Drainanschluß D der EEPROM-Zelle 1 in schwebendem Zustand ist. Der Gateanschluß G der EEPROM-Zelle 1 ist mit Massepotential beaufschlagt, während der Sourceanschluß S mit einer hohen Spannung HV, die zum Beispiel +12 V betragen kann, beaufschlagt ist. Durch diese hohe Spannung HV werden die Ladungstrager auf dem schwebenden Gate FG angeregt, durch das Gateoxid zum Sourcegebiet SG zu tunneln. Wenn die hohe Spannung HV jedoch zu lange an den Sourceanschluß S angelegt wird, tunneln mehr Elektronen vom schwebenden Gate FG zum Sourcegebiet SG, als beim Programmiervorgang dorthin gelangten. Dadurch lädt sich das schwebende Gate FG positiv auf. Diese positive Aufladung wird als "Over-Erasure" bezeichnet und muß bei einer üblichen Verwendung von EEPROM-Zellen als Speicherzellen unter allen Umständen vermieden werden, da sonst ein Lesefehler eintritt.

Bei der vorliegenden Erfindung führt ein solcher "Over-Erasure"-Vorgang jedoch zu einer erfindungsgemäßen Aufladung des schwebenden Gates mit einer Ladung, die einen zum Kanaltyp des die EEPROM-Zelle bildenden MOSFETs entgegengesetzten Ladungstragertyp hat. Das bedeutet also, daß bei dem in Figur 3 dargestellten n-Kanal-MOSFET, der die EEPROM-Zelle 1 bildet, das schwebende Gate FG positiv aufgeladen ist, so daß sich im Kanalbereich K ständig negative Ladungstrager, also Elektronen ansammeln, so daß eine derart behandelte EEPROM-Zelle nach außen wie ein selbstleitender Feldeffekttransistor wirkt. In Figur 4 ist eine erfinäungsgemäße Konstantstromquelle mit einer "Over-Erased"-EEPROM-Zelle 1 dargestellt. Diese "Over-Erased"-EEPROM-Zelle ist in Serie mit einem Lastwiderstand R_{L} zwischen zwei Versorgungspotentiale V_{DD} und V_{SS} geschaltet. Das erste Versorgungspotential V_{DD} kann dabei beispielsweise etwa 5 V betragen, wahrend das zweite Versorgungspotential V_{SS} 0 V beträgt. Der Gateanschluß der "Over-Erased"-EEPROM-Zelle 1 ist ebenfalls mit 0 V, also dem zweiten Versorgungspotential V_{SS} verbunden. Der Drainanschluß D der "Over-Erased"-EEPROM-Zelle 1 ist über einen Schalter 2 mit dem Lastwiderstand R_{L} verbunden. Der Schalter 2 ist mit einem selbstsperrenden n-Kanal-MOSFET, dessen Gateanschluß mit dem ersten Versorgungspotential V_{DD} beaufschlagt ist, gebildet. Es kann jedoch auch ein beliebiger anderer Schalter verwendet werden. Dieser Schalter 2 dient dazu, den Lastwiderstand R_{L} beim Laden des schwebenden Gates der EEPROM-Zelle 1 durch einen "Over-Erasure"-vorgang von der hierzu anzulegenden hohen Spannung HV abzutrennen. Wie in Figur 3 gezeigt ist, geschieht dies dadurch, daß an das Gate des durch einen selbstsperrenden Kanal-MOSFET gebildeten Schalters 2 das zweite Potential V_{SS} von 0 V angelegt wird, wodurch dieser MOSFET sperrt. In vorteilhafter Weiterbildung dieser Konstantstromquelle kann zwischen den Sourceanschluß der EEPROM-Zelle 1 und das zweite Potential V_{SS} ein weiterer nicht dargestellter Widerstand geschaltet werden, durch den der Innenwiderstand der Konstantstromquelle erhöht werden kann.

Statt der Verwendung eines n-Kanal-MOSFETs als EEPROM-Zelle kann natürlich auch ein p-Kanal-MOSFET verwendet werden, wobei jedoch die zum Löschen dieser EEPROM-Zelle als auch zum Betreiben der "Over-Erased"-EEPROM-Zelle als Konstantstromquelle benötigten Spannungen in geeigneter Weise geandert werden müssen.

## Patentansprüche

1. Konstantstromquelle mit einem MOSFET, dessen Drainanschluß (D) mit einem ersten Anschluß der Stromquelle und dessen Sourceanschluß (S) und Steuergateanschluß (SG) mit einem zweiten Anschluß der Stromquelle verbunden sind,
**dadurch gekennzeichnet,**
daß zwischen dem Steuergate (SG) und dem Kanal (K) des FETs ein schwebendes Gate (FG) mit einer Ladung vom zum Kanaltyp des FET entgegengesetzten Ladungsträgertyp angeordnet ist.

2. Konstantstromquelle nach Anspruch 1,
**dadurch gekennzeichnet,**
daß der FET zum Aufbringen der Ladung auf das schwebende Gate mit einer Hochvoltquelle verbindbar und von einer zu versorgenden Last trennbar ist.

3. Konstantstromquelle nach Anspruch 1 oder 2,
**dadurch gekennzeichnet,**
daß zwischen dem Sourceanschluß des FET und dem zweiten Anschluß der Stromquelle ein Widerstand angeordnet ist.

## Claims

1. Constant-current source with a MOSFET, the drain electrode (D) of which is connected to one terminal of the current source and the source electrode (S) and control gate electrode (SO) of which are connected to a second terminal of the current source, characterized in that a floating gate (FG) having a charge of the opposite charge-carrier type to the channel type of the FET is arranged between the control gate (SG) and the channel (K) of the FET.

2. Constant-current source according to Claim 1, characterized in that, in order to apply the charge to the floating gate, the FET can be connected to a high-voltage source and can be isolated from a load to be supplied.

3. Constant-current source according to Claim 1 or 2, characterized in that a resistor is arranged between the source electrode of the FET and the second terminal of the current source.

## Revendications

1. Source de courant constant, comportant un MOSFET dont la borne (D) de drain est reliée à une première borne de la source de courant et dont la borne (S) de source et la borne (SG) de grille de commande sont reliées à une deuxième borne de la source de courant,
caractérisée
en ce qu'il est disposé entre la grille (SG) de commande et le canal (K) du FET une grille (FG) flottante ayant une charge du type de porteurs de charge opposé au type de canal du FET.

2. Source de courant constant suivant la revendication 1,
caractérisée
en ce que le FET peut être relié à une source de haute tension pour déposer la charge sur la grille flottante et peut être séparé par une charge à alimenter.

3. Source de courant constant suivant la revendication 1 ou 2, caractérisée en ce qu'il est disposé une résistance entre la borne de source du FET et la deuxième borne de la source de courant.
